# EUROPEAN PATENT APPLICATION

(11) **EP 4 496 214 A1**
(43) Date of publication of application: **22.01.2025**
(21) Application number: 23714784.8
(22) Date of filing: 13.03.2023
(51) Int. Cl.: H02S 20/25, F24S 20/69, H01L 31/048

(54) **PHOTOELECTRIC CONSTRUCTION BLOCK**

(30) Priority: 16.03.2022 ES 202230221
(71) Applicant: Flexbrick, S.L., 08781 Hostalets de Pierola (Barcelona) (ES)
(72) Inventor: SARRABLO MORENO, Vicente, 08860 Castelldefels (Barcelona) (ES)
(74) Representative: Torner, Juncosa I Associats, SL
(86) International application number: PCT/ES2023/070142
(87) International publication number: WO 2023/175214

(57) **Abstract**

The invention relates to a photoelectric building block comprising a rigid support (1), made of a single extruded piece of non-metal material, provided with a front with a first coupling configuration (10) formed by a sunken channel (11) between two opposing parallel grooved guides (12) that define a narrowing of the opening of the sunken channel (11), at least one photoelectric panel (2) with a second coupling configuration (20) inserted into the sunken channel (11) and having opposite coupling ends (21) inserted into the two grooved guides (12); wherein the photoelectric building block further comprises a retainer device (30) which exerts a thrust on the opposite coupling ends (21) of the second coupling configuration (20), moving them away from the bottom of said sunken channel (11) and thrusting them against the lower surface (13) of the two grooved guides (12), retaining the photoelectric panel (2).

## Description

### Field of the Art

The present invention relates to a photoelectric building block comprising a photoelectric panel coupled to a high-strength and high-durability rigid support, typically ceramic or mortar supports, suitable for architectural integration, although other materials such as plastics, for example, are also contemplated.

A photoelectric panel is understood as a device, in the form of a flat panel, which is capable of generating electric energy upon receiving direct light, such as a photovoltaic panel, for example, or which is capable of generating light upon receiving electric energy, such as a light panel or a screen, for example, as a result of the photoelectric effect.

### State of the Art

Photoelectric building blocks are known, said blocks comprising a photoelectric panel fixed on a rigid support and being made of a non-metal material, and therefore being readily integrable in buildings made with techniques that are common in the sector, with the rigid support typically being ceramic, mortar, or stone panels and being intended as a roof tile, or a façade cladding, or even a brick.

For example, document CN209556279U describes a ceramic brick with a central recess in which a photoelectric panel is housed and retained by means of an adhesive. Due to its geometry, the ceramic brick described in this document cannot be manufactured by means of an extrusion process, increasing the manufacturing cost and slowing down manufacture. Furthermore, the fixing of the photoelectric panel by means of adhesives prevents or hinders the maintenance or replacement of the photoelectric panel, if needed, and also hinders the reuse or recycling of the assembly in the future.

Document US2014007528A1 also describes a building block including a rigid support, in the form of a mortar block, with a photoelectric panel attached thereto, in this case through an interposed metal structure formed by a folded sheet metal. Both the manufacturing of the interposed structure and the fixing thereof to the rigid mortar support are not optimized for a quick and cost-effective mass production.

Document US5112408A describes a building block formed by a rigid support with a sunken channel defined between two opposing parallel grooved guides into which two side edges of a photovoltaic panel are inserted. This document describes the inclusion of a toothed profile inside the grooved guides, on opposing faces, complementary with a toothed profile provided on the side edges of the photovoltaic panel. The toothed profiles are configured to allow the sliding insertion of the photovoltaic panel from an open end of the rigid support towards a closed end in a direction parallel to the grooved guides and to retain the photovoltaic panel inside the sunken channel. The rigid support, with the geometry defined in this document, requires a complex mold in its manufacture or machining, increasing the manufacturing cost. Furthermore, the toothed profiles proposed in this document prevent the sliding removal of the photovoltaic panel in a direction parallel to the grooved guides but does not prevent vibrations of the photovoltaic panel in a direction perpendicular to the photovoltaic panel, for example, due to the wind.

Document CN113872502A also describes a building block formed by a rigid support with a sunken channel defined between two opposing parallel grooved guides into which two side edges of a photovoltaic panel are inserted. However, this document does not mention any retainer device which prevents the removal or vibration of the photovoltaic panel.

The present invention solves these and other problems.

### Brief Description of the Invention

The present invention relates to a photoelectric building block.

A building block is understood as an element suitable for architectural integration in a building, typically as a part constituting a wall, cladding, latticework, etc.

In a way that is already known, the proposed photoelectric building block comprises:
- a rigid support, made of a single piece of extrudable non-metal material, provided with a front with a first coupling configuration and with a back; and
- at least one photoelectric panel with a second coupling configuration attached to the first coupling configuration, such that said photoelectric panel covers at least part of the front of the rigid support; wherein

the first coupling configuration consists of a sunken channel, formed on the front of the rigid support, between two opposing parallel grooved guides that define a narrowing of the opening of the sunken channel, each grooved guide including a lower surface facing the bottom of the sunken channel;
the second coupling configuration is inserted into the sunken channel and has opposite coupling ends inserted into the two opposing grooved guides, the separation between the opposite coupling ends being greater than the opening of the sunken channel; and wherein the photoelectric building block further comprises a retainer device retaining the photoelectric panel with respect to the rigid support, hindering the sliding of the second coupling configuration with respect to the first coupling configuration.

The rigid support which is made of an extrudable non-metal material is understood as a panel that is made up of a material which can be formed by means of an extrusion process. Non-metal materials typically formed by extrusion are, for example, ceramic, mortar, and also plastic materials.

Metal materials present corrosion problems, are electrically conductive, and cause a high environmental impact in order to produce them. Furthermore, they present other problems that hinder architectural integration such as, for example, the fact that they do not adhere readily to common building materials, for example by means of mortar, requiring costly mechanical fixing elements. Another problem is that they have thermal expansions that are much higher than those of other materials commonly used in construction, such as ceramic, concrete, and mortar, so special attachments which absorb said differential expansions are required for their integration.

All these problems are prevented by using a rigid support made of an extrudable non-metal material, preferably ceramic, mortar, concrete materials or even plastic materials that do not have expansions that are so different from common building materials.

The rigid support will have two main faces, one of which will be the front of the rigid support, provided for being oriented towards the sun, and the other main face opposite the front will be the back. The rigid support can have other faces on the perimeter thereof such as, for example, two end portions and two sides.

The photoelectric panel will cover at least part of the front of the rigid support, being exposed to sunlight and visible to possible users.

A photoelectric panel is understood as a device, in the form of a flat panel, which is capable of generating electric energy upon receiving direct light, such as a photovoltaic panel, for example, or which is capable of generating light upon receiving electric energy, such as a light panel or a screen, for example, as a result of the photoelectric effect.

For example, the photovoltaic panel can be a rigid or flexible panel made of silicon, perovskite, or another material which produces electric energy under the direct incidence of sunlight, as a result of the photoelectric effect.

For example, the light panel can be a LED (light-emitting diode) panel, an OLED (organic light-emitting diode) panel, or another equivalent technology, which emits light for illumination, signaling, or other uses.

For example, the screen can be an AMOLED (active-matrix organic light-emitting diode) screen, an LCD (liquid crystal display) screen with LED backlighting, or another equivalent technology.

According to the foregoing, the front of the rigid support has two opposing parallel grooved guides and a sunken channel delimited between the mentioned grooved guides.

The edges of the two parallel guides determine a narrowing of the opening of the sunken channel, i.e., the distance between said edges is smaller than the maximum width of the sunken channel including the inner width of the two grooved guides.

Said narrowing determines which part of the walls delimiting each grooved guide will be facing the bottom of the sunken channel and constitute a lower surface of the grooved guide.

An element, constituting a second coupling configuration, with a width greater than the width of the opening of the sunken channel, contained in the sunken channel, with the opposite coupling ends thereof inserted into the grooved guides, will be anchored to the rigid support and constitute the second coupling configuration.

The second coupling configuration, inserted into the sunken channel, could slide along the grooved guides or vibrate therein, particularly considering that the rigid support can have manufacturing tolerances greater than the manufacturing tolerances of the photoelectric panel, particularly when the rigid support is obtained by means of an extrusion process, and optionally by means of a subsequent firing step, such as when the rigid support is made of a ceramic material. Said different manufacturing tolerances between the rigid support and the photoelectric panel prevent a snug, play-free insertion of the first and second coupling configurations.

The inclusion of a retainer device is proposed to block said sliding and vibration.

In a way that is not already known, the present invention further proposes the following:
- the rigid support has a cross-section, perpendicular to the two grooved guides, that is constant along the entire length thereof, defining a geometry suitable for manufacturing same by extrusion;
- the retainer device exerts a thrust urging the opposite coupling ends of the second coupling configuration against the lower surface of the two grooved guides, moving them away from the bottom of said sunken channel.

As a result of the constant cross-section of the rigid support which allows a cost-effective manufacturing by extrusion, the sunken channel will be accessible through the end portions of the rigid support from where the ends of the grooved guides are open and accessible, allowing the insertion into the second coupling configuration by means of sliding in the longitudinal direction of the grooved guides. The sunken channel will also be accessible through an opening defined between the edges of the two parallel grooved guides.

The proposed retainer device, as a result of thrusting the opposite coupling ends against the lower surface of the two grooved guides facing the bottom of the sunken channel, retains the photoelectric panel with respect to the rigid support, hindering the sliding of the second coupling configuration with respect to the first coupling configuration and preventing the vibration thereof, while allowing the rigid support to be manufactured by extrusion at the same time, allowing a highly cost-effective serial manufacturing.

The pressure of the opposite coupling ends against the lower surface of the grooved guides will block the sliding movement of the second coupling configuration along the two grooved guides, preventing the sliding of the photoelectric panel fixed to the rigid support through said second coupling configuration.

Preferably, the retainer device is housed between the photoelectric panel and the bottom of the sunken channel like a wedge, causing the mentioned thrust on the opposite coupling ends against the lower surface of the two grooved guides. In this way, the retainer device inserted between the photoelectric panel and the bottom of the sunken channel will generate a thrust, moving the photoelectric panel and its corresponding opposite coupling ends away from the sunken channel.

Optionally, the retainer device, the photoelectric panel, or at least one of the opposite coupling ends thereof can be elastically deformed at least partially. Said elastic deformation facilitates the insertion of the retainer device, with the elastic deformation occurring during said insertion, thrusting the photoelectric panel outwardly with respect to the sunken channel.

For example, the retainer device may comprise two runners arranged between the photoelectric panel and the bottom of the sunken channel, which can slide from the center of the sunken channel towards the two grooved guides.

According to another embodiment, the bottom of the sunken channel may be concave, defining a narrowing of the distance between the photoelectric panel and the bottom of the sunken channel towards the two grooved guides. In this way, the wedge effect will increase upon sliding the runners towards the grooved guides.

Each runner may optionally include a guide flange supported on an end portion of the rigid support, and/or a seating flange on which there rests a transverse edge of the photoelectric panel located between the grooved guides. These flanges will allow fixing the position of the runners with respect to the rigid support and/or of the photoelectric panel with respect to the runners.

According to another embodiment, the retainer device may comprise one or more wedges inserted between the photoelectric panel and the bottom of the sunken channel.

The rigid support may include through holes, parallel to the grooved guides, for example, so as to reduce its weight. In such case, each wedge may include an anchoring, or an anchoring provided with a toothed or barbed configuration at the edges thereof, snugly inserted into one of said through holes, fixing the position thereof.

It is also proposed that each wedge may include a seating flange on which there rests a transverse edge of the photoelectric panel located between the grooved guides.

According to another alternative embodiment, the retainer device is made up of a convexity and/or projections protruding from the bottom of the sunken channel configured to retain the photoelectric panel, which is flexible, in a bent position between the lower surface of the grooved guides and the convexity and/or protuberances of the sunken channel. According to this embodiment, the photoelectric panel must be bent for the sliding insertion thereof into the sunken channel from an end portion of the rigid support, keeping it bent while it slides to its final location. Once there, the actual elastic deformation of the photoelectric panel will thrust its central region against the convexity and/or the projections protruding from the bottom of the sunken channel, while at the same time thrust the opposite coupling ends against the lower surface of the two grooved guides. Preferably, the convexity and/or the protuberances are interposed in a straight line between the lower surface of the two grooved guides, preventing the photoelectric panel from being flat.

According to another embodiment, the retainer device is made up of the photoelectric panel, which is flexible and retained between the grooved guides in a bent position, and the bottom of the sunken channel, which is concave and has a width, measured in a straight line between the opposing inner portions of both grooved guides, that is equal to or greater than a length between the two opposite coupling ends measured in a straight line when the photoelectric panel is retained in a bent position, and that is less than said length between the opposite coupling ends measured in a straight line when the photoelectric panel is uncoupled and flat, the bending of the photoelectric panel causing the mentioned thrust on the opposite coupling ends against the lower surface of the two grooved guides. According to this embodiment, the photoelectric panel is retained inside the sunken channel in a bent position, and therefore subjected to an elastic expansion force to try to recover its flat position. Said elastic force is what will thrust the photoelectric panel, moving it away from the bottom of the sunken channel, retaining it inside the grooved guides, so in this case it will be the photoelectric panel itself which acts as a retainer device.

It will be understood that references to geometric position such as, for example, parallel, perpendicular, tangent, etc., allow deviations of up to ±5° with respect to the theoretical position defined by said nomenclature.

Other features of the invention will be apparent from the following detailed description of an embodiment.

### Brief Description of the Figures

The foregoing and other advantages and features will be more fully understood based on the following detailed description of an embodiment in reference to the attached drawings which must be interpreted in a non-limiting illustrative manner, in which:
Figure 1 shows a perspective view of the photoelectric building block, with the photoelectric panel separated from the assembly, according to a first embodiment in which the retainer device comprises two runners, shown in a released position.
Figure 2 shows the same photoelectric building block as Figure 1 but in an assembled position, with the runners shown in a blocking position, and with an enlarged view of an end of one of the grooved guides.
Figure 3 shows a plan view of a photoelectric building block according to the embodiment shown in Figure 2, in which the bottom of the concave sunken channel is shown in an exaggerated manner.
Figure 4 shows a plan view of a photoelectric building block according to the embodiment shown in Figure 2, in which the bent photoelectric panel is shown in an exaggerated manner.
Figure 5 shows a perspective view of the photoelectric building block, with the retainer device separated from the assembly, according to a second embodiment in which the retainer device comprises two compressible wedges inserted between the photoelectric panel and the bottom of the sunken channel.
Figure 6 shows a plan view of a photoelectric building block according to a third embodiment, in which the photoelectric panel bent by two protuberances of the bottom of the sunken channel is shown in an exaggerated manner.
Figure 7 shows a side elevational view of a photoelectric building block according to a fourth embodiment, according to which at least part of the sunken channel is in a part of the front of the rigid support which is inclined with respect to the vertical and not parallel with respect to the vertical back of the rigid support. This embodiment further shows a rigid support integrating two sunken channels and two photoelectric panels.

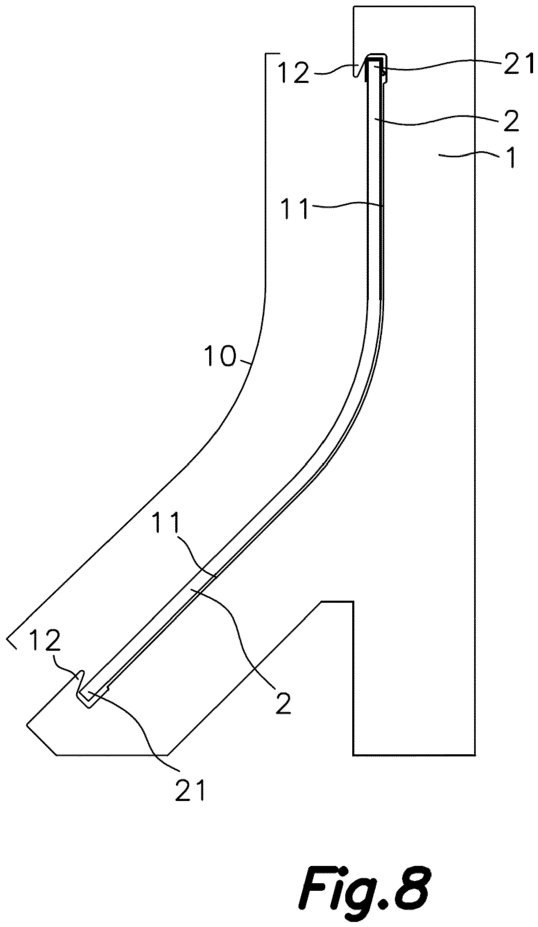

Figure 8 shows a side elevational view of a photoelectric building block according to a fifth embodiment, according to which the photoelectric panel is a flexible panel inserted, in a bent position, into a convex sunken channel, such that while trying to recover its horizontal position, the photoelectric panel causes the separation of the two opposite coupling ends, causing the snug insertion thereof inside the grooved guides, the concave sunken channel, and the bent photoelectric panel acting as a retainer device.

### Detailed Description of an Embodiment

The attached figures show non-limiting illustrative embodiments of the present invention.

According to one embodiment, the present invention relates to a photoelectric building block suitable for architectural integration.

The photoelectric building block comprises a rigid support (1) made of a single piece of extrudable non-metal material. Typically, said rigid support (1) will be a ceramic or mortar block such as, for example, a brick or the like, or a flat ceramic or mortar panel such as, for example, a tile or the like. Optionally, said rigid support (1) can be made of plastic.

The rigid support (1) is provided with a front with a first coupling configuration (10) and with a back.

The photoelectric building block also comprises at least one photoelectric panel (2) including a second coupling configuration (20).

The second coupling configuration (20) is attached to the first coupling configuration (10), fixing the photoelectric panel (2) to the rigid support (1).

The photoelectric panel (2) will cover at least part of the front of the rigid support (1).

The first coupling configuration (10) consists of a sunken channel (11), formed on the front of the rigid support (1), between two opposing parallel grooved guides (12) that define a narrowing of the opening of the sunken channel (11), each grooved guide (12) including a lower surface (13) facing the bottom of the sunken channel (11).

According to one embodiment, the lower surfaces (13) of the two grooved guides (12) can be coplanar to one another, or alternatively can slope towards the opening of the sunken channeling (11).

The rigid support (1) has a cross-section, perpendicular to the two grooved guides (12), that is constant along the entire length thereof, defining a geometry suitable for manufacturing same by extrusion. This geometry, together with the material selected to be extrudable, allows said rigid support to be manufactured by means of extrusion, thereby achieving a quick, efficient, and highly cost-effective serial manufacturing, said rigid support including the two grooved guides (12) without requiring subsequent manufacturing operations. Therefore, the rigid support is preferably manufactured by means of extrusion.

The second coupling configuration (20) of the photoelectric panel (2) is inserted into the sunken channel (11) and has opposite coupling ends (21) inserted into the two opposing grooved guides (12), the separation between the opposite coupling ends (21) being greater than the opening of the sunken channel (11).

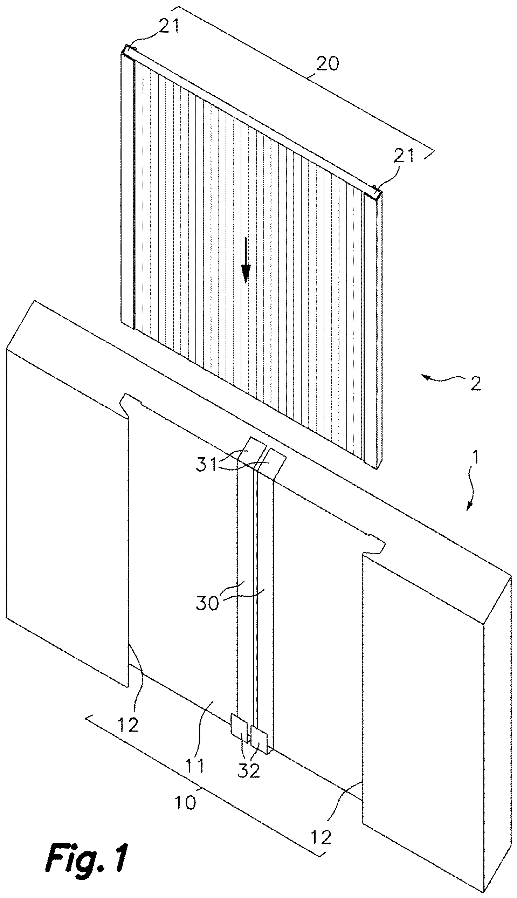

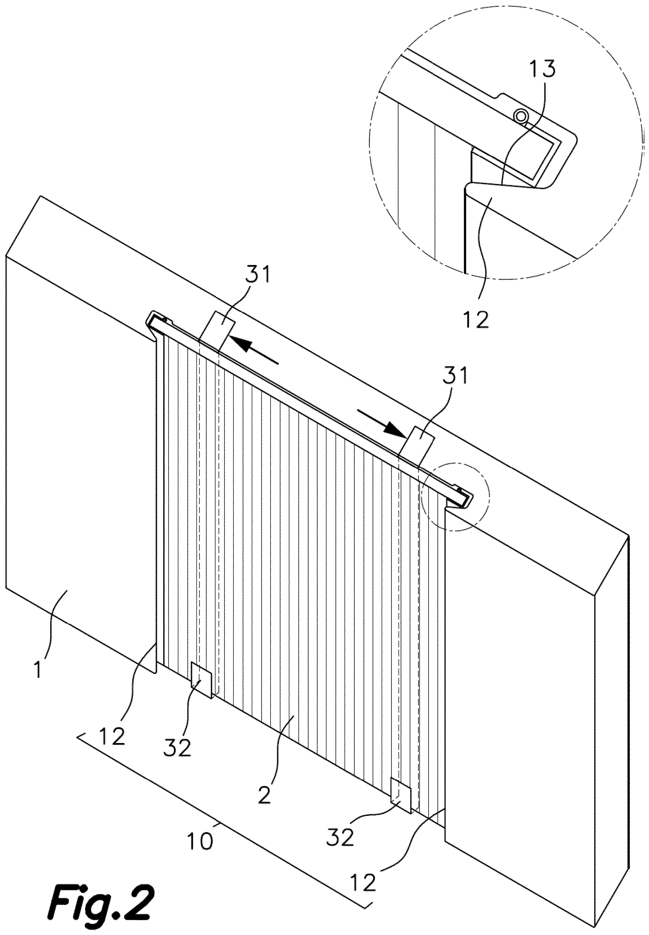

According to the preferred embodiment shown in Figures 1 to 6, the second coupling configuration (20) is made up of the photoelectric panel (2) itself, which is inserted into the sunken channel (11). The photoelectric panel (2) has two side edges parallel to one another. Said side edges are inserted into the two grooved guides (12), said side edges constituting the opposite coupling ends (21).

According to the preferred embodiment, the side edges of the photoelectric panel (2), or both the side edges and the transverse edges of the photoelectric panel (2), include a protective profile, typically a U-shape profile, coupled along the length thereof, preventing direct contact between the photoelectric panel (2) and the rigid support (1).

The photoelectric panel (2) further comprises at least two electric conducting cables connected to two opposite edges of the photoelectric panel (2). At least part of the two electric conducting cables will extend in the longitudinal direction of the grooved guides, over the back of the photoelectric panel.

For example, the two electric conducting cables can be connected to the two side edges of the photoelectric panel inserted into the two grooved guides (12). Therefore, the electric conducting cables will be at least partially contained inside the grooved guides (12), at least from a point of connection with the photoelectric panel (2) to an end portion of the rigid support (1).

According to another embodiment, the electric conducting cables will be connected to the two transverse edges of the photoelectric panel (2) located between the grooved guides (12), and one of them will run over the back of the photoelectric panel in the longitudinal direction, for example, along a central region of the photoelectric panel comprised between the two side edges.

According to one embodiment, the electric conducting cable is arranged on the back of the photoelectric panel (2), with the bottom of the sunken channel (11) including a longitudinal recess that allows housing said electric conducting cable without it being pressed against the bottom of the sunken channel (11).

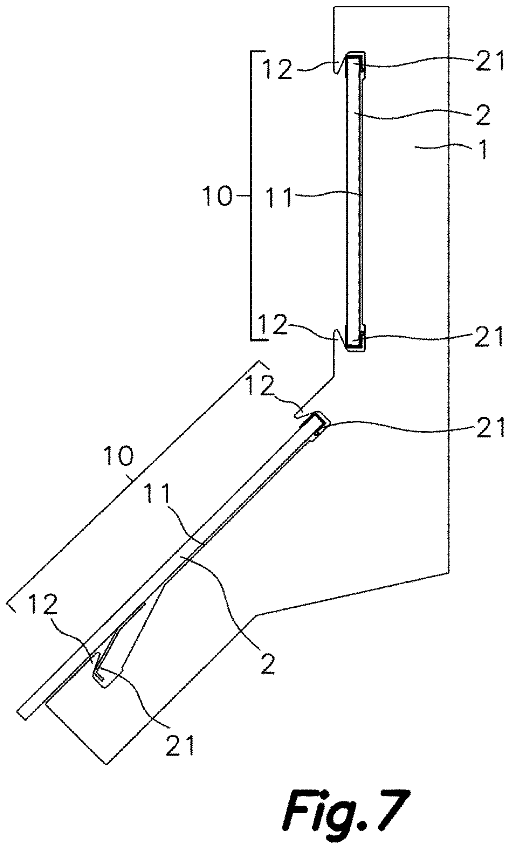

Alternatively, the second coupling configuration (20) comprises one or more flanges adhered to the back of the photoelectric panel (2), as shown in Figure 7.

According to this embodiment that is shown, the one or more flanges are inserted into one of the grooved guides (12) and a side edge of the photoelectric panel (2) is inserted into the other grooved guide (12), with the assembly of the one or more flanges and the side edge of the photoelectric panel constituting the opposite coupling ends (21).

Alternatively, according to an embodiment that is not shown, said one or more flanges will be inserted simultaneously into both grooved guides (12), said one or more flanges constituting the opposite coupling ends (21).

The photoelectric building block further comprises a retainer device (30) which exerts a thrust on the opposite coupling ends (21) of the second coupling configuration (20), moving them away from the bottom of said sunken channel (11) and thrusting them against the lower surface (13) of the two grooved guides (12), retaining the photoelectric panel (2) with respect to the rigid support (1), hindering the sliding of the second coupling configuration (20) with respect to the first coupling configuration (10).

According to one embodiment shown in Figures 1 to 4, the retainer device (30) comprises two runners arranged between the photoelectric panel (2) and the bottom of the sunken channel (11), which can slide from the center of the sunken channel (11) towards the two grooved guides (12), acting as wedges between the photoelectric panel (2) and the bottom of the sunken channel (11).

Each runner may further include a guide flange (31) supported on an end portion of the rigid support (1), and/or a seating flange (32) on which there rests a transverse edge of the photoelectric panel (2) located between the grooved guides (12).

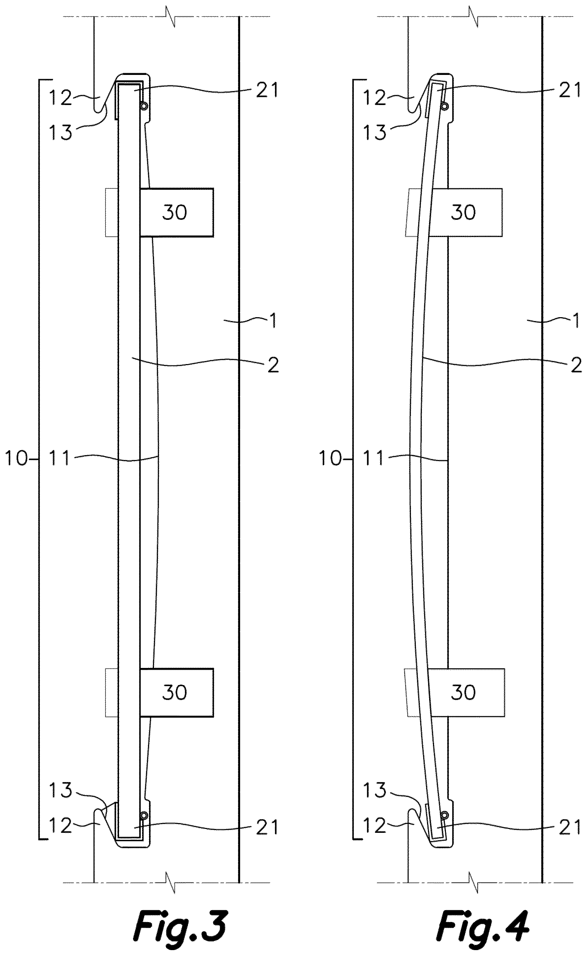

Optionally, it is contemplated that the bottom of the sunken channel (11) is concave, as shown in Figure 3, and/or that the photoelectric panel (2) is flexible, as shown in Figure 4.

Any of these alternatives will allow the sliding of the runners towards the ends to increase the pressure of the opposite coupling ends (21) against the lower surfaces (13).

Another additional or alternative embodiment that is not shown would be the inclusion of a compressible element arranged between the opposite coupling ends (21) and the lower surface (13) of the grooved guides (12).

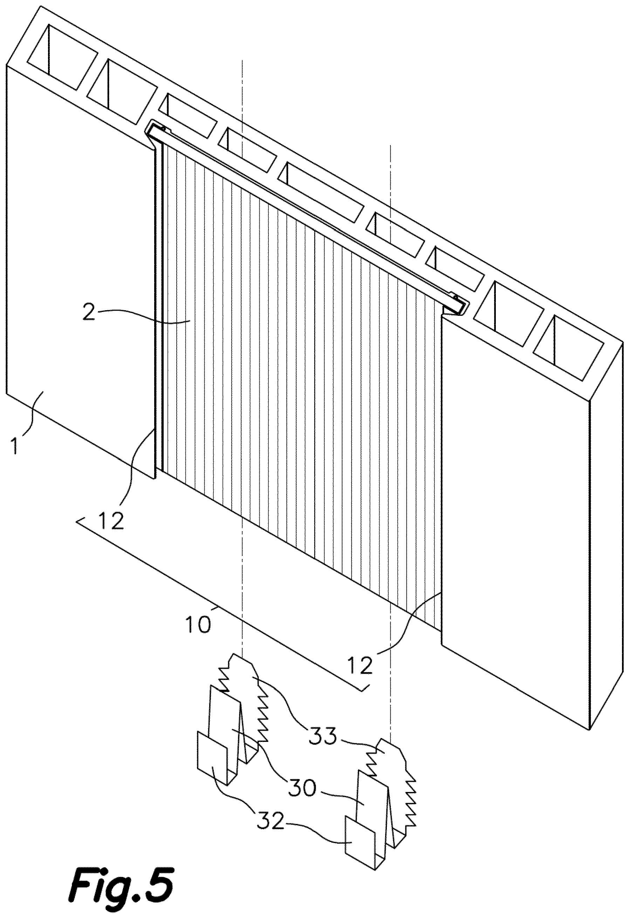

Another embodiment of the retainer device (30) shown in Figure 5 comprises one or more elastically compressible wedges inserted between the photoelectric panel (2) and the bottom of the sunken channel (11), said wedges constituting the retainer device (30).

The rigid support (1) may include through holes parallel to the grooved guides (12), which may also be obtained by means of the extrusion process.

In such case, each wedge may include an anchoring (33) snugly inserted into one of said through holes, fixing the position thereof. The anchoring (33) may have a toothed or barbed configuration at the edges thereof in contact with the inner faces of the through holes, which ensure a proper fixing, and a simple and low-cost construction formed by a die-cut and bent metal sheet.

Each wedge can also include a seating flange (32) on which there rests a transverse edge of the photoelectric panel (2) located between the grooved guides (12).

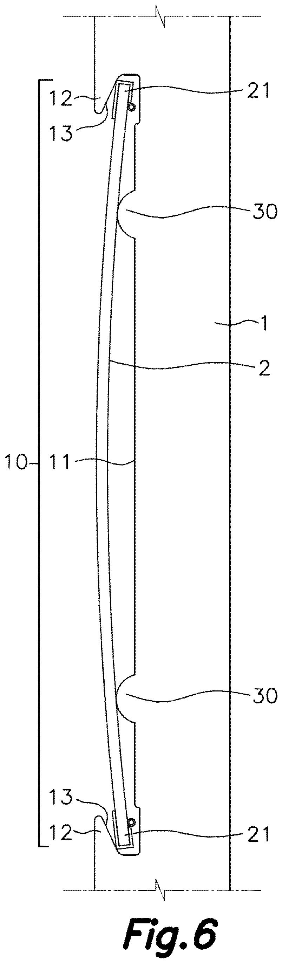

According to another embodiment shown in Figure 6, the bottom of the sunken channel (11) is convex and/or includes protruding projections. In such case, the photoelectric panel (2) will be flexible and retained, in a bent position, between the lower surface (13) of the grooved guides (12) and the convex bottom and/or the protuberances of the sunken channel (11). The assembly of the flexible photoelectric panel (2) and the convex bottom and/or the bottom with protuberances will constitute the retainer device (30).

According to another alternative embodiment, the photoelectric panel (2) is flexible and retained between the grooved guides (12) in a bent position. The bottom of the sunken channel (11) is concave, and the width of the sunken channel (11), measured in a straight line between the opposing inner portions of both grooved guides (12), is smaller than the length of the photoelectric panel (2) measured in a straight line between the two opposite coupling ends when it is flat, and equal to or greater than said length of the photoelectric panel (2) measured in a straight line between the two opposite coupling ends when the photoelectric panel is retained in a bent position. The assembly of the flexible photoelectric panel (2) and the concave bottom constitutes the retainer device (30).

The bent photoelectric panel (2) tends to recover its horizontal position through elastic bending, however, the maximum width of the sunken channel, measured in a straight line between the opposing bottoms of the two grooved guides (12), prevents the photoelectric panel from recovering said horizontal position, with the panel being retained.

According to one embodiment, the photoelectric panel (2) is a photovoltaic generator panel, or a light-emitting panel, or a moving image-emitting screen.

It is also proposed that the photoelectric panel (2) can be cantilevered from the sunken channel (11), for example, at the open ends thereof.

According to one embodiment shown in Figure 7, at least part of the front of the rigid support (1), which contains at least part of the sunken channel (11), and the back of the rigid support are not parallel, with the photoelectric panel being inclined with respect to the back, improving the sun exposure thereof.

Therefore, the back and at least part of the front are not parallel, increasing solar energy capture or the visibility of the photoelectric panel.

## Claims

1. A photoelectric building block comprising:
a rigid support (1), made of a single piece of extrudable non-metal material, provided with a front with a first coupling configuration (10) and with a back;
at least one photoelectric panel (2) with a second coupling configuration (20) attached to the first coupling configuration (10), said photoelectric panel (2) covering at least part of the front of the rigid support (1); wherein
the first coupling configuration (10) consists of a sunken channel (11), formed on the front of the rigid support (1), between two opposing grooved guides (12) parallel to each other, the grooved guides (12) defining a narrowing of the opening of the sunken channel (11), each grooved guide (12) including a lower surface (13) facing the bottom of the sunken channel (11);
the second coupling configuration (20) is inserted into the sunken channel (11) and has opposite coupling ends (21) inserted into the two opposing grooved guides (12), the separation between the opposite coupling ends (21) being greater than the opening of the sunken channel (11); wherein
the photoelectric building block further comprises a retainer device (30) retaining the photoelectric panel (2) with respect to the rigid support (1), hindering the sliding of the second coupling configuration (20) with respect to the first coupling configuration (10);
**characterized in that**
the rigid support (1) has a cross-section, perpendicular to the two grooved guides (12), that is constant along the entire length thereof, defining a geometry suitable for manufacturing same by extrusion; and
the retainer device (30) urges the opposite coupling ends (21) of the second coupling configuration (20) towards the lower surface (13) of the two grooved guides (12), moving them away from the bottom of said sunken channel (11).

2. The photoelectric building block according to claim 1, wherein the retainer device (30) is housed between the photoelectric panel (2) and the bottom of the sunken channel (11) acting as a wedge, causing the mentioned urging of the opposite coupling ends (21) towards the lower surface (13) of the two grooved guides (12).

3. The photoelectric building block according to claim 2, wherein the retainer device (30), the photoelectric panel (2), or at least one of the opposite coupling ends (21) thereof is elastically deformed at least partially.

4. The photoelectric building block according to claim 2 or 3, wherein the retainer device (30) comprises two runners arranged between the photoelectric panel (2) and the bottom of the sunken channel (11), which can slide from the center of the sunken channel (11) towards the two grooved guides (12).

5. The photoelectric building block according to claim 4, wherein the bottom of the sunken channel (11) is concave, defining a narrowing of the distance between the photoelectric panel (2) and the bottom of the sunken channel (11) towards the two grooved guides (12).

6. The photoelectric building block according to claim 4 or 5, wherein each runner further includes a guide flange (31) supported on an end portion of the rigid support (1), and/or a seating flange (32) on which a transverse edge of the photoelectric panel (1), located between the grooved guides (12), rests.

7. The photoelectric building block according to claim 2 or 3, wherein the retainer device (30) comprises one or more wedges inserted between the photoelectric panel (2) and the bottom of the sunken channel (11).

8. The photoelectric building block according to claim 7, wherein the rigid support (1) includes through holes parallel to the grooved guides (12), and wherein each wedge includes an anchoring (33), or an anchoring (33) provided with a toothed or barbed configuration at the edges thereof, snugly inserted into one of said through holes, fixing the position thereof.

9. The photoelectric building block according to claim 7 or 8, wherein each wedge includes a seating flange (32) on which there rests a transverse edge of the photoelectric panel (2) located between the grooved guides (12).

10. The photoelectric building block according to claim 2 or 3, wherein the retainer device (30) is made up of a convexity and/or projections protruding from the bottom of the sunken channel (11) configured to retain the photoelectric panel (2), which is flexible, in a bent position between the lower surface (13) of the grooved guides (12) and the convexity and/or protuberances of the sunken channel (11).

11. The photoelectric building block according to claim 1, wherein the retainer device (30) is made up of the photoelectric panel (2), which is flexible and retained between the grooved guides (12) in a bent position, and the bottom of the sunken channel (11), which is concave and has a width, measured in a straight line between the opposing inner portions of both grooved guides (12), that is equal to or greater than a length between the two opposite coupling ends measured in a straight line when the photoelectric panel is retained in a bent position, and that is less than said length between the opposite coupling ends measured in a straight line when the photoelectric panel (2) is uncoupled and flat, the bending of the photoelectric panel (2) causing the mentioned thrust on the opposite coupling ends (21) against the lower surface (13) of the two grooved guides (12).

12. The photoelectric building block according to any one of the preceding claims, wherein the lower surfaces (13) of the two grooved guides (12) are coplanar.

13. The photoelectric building block according to any one of preceding claims 1 to 11, wherein the lower surfaces (13) of the two grooved guides (12) slope towards the opening of the sunken channeling (11).

14. The photoelectric building block according to any one of the preceding claims, wherein the photoelectric panel (2) is inserted into the sunken channel (11) and constitutes the second coupling configuration (20), with two parallel side edges of the photoelectric panel (2) being inserted into the two grooved guides (12), said side edges constituting the opposite coupling ends (21).

15. The photoelectric building block according to claim 14, wherein the photoelectric panel (2) comprises at least two electric conducting cables connected to two opposite edges of the photoelectric panel (2), at least part of the two electric conducting cables extends in the longitudinal direction of the grooved guides, over the back of the photoelectric panel.

16. The photoelectric building block according to any one of preceding claims 1 to 13, wherein the second coupling configuration (20) comprises one or more flanges adhered to the back of the photoelectric panel (2), said one or more flanges being inserted into both grooved guides (12), said one or more flanges constituting the opposite coupling ends (21), or being inserted into one of the grooved guides (12) and a side edge of the photoelectric panel (2) being inserted into the other grooved guide (12), with the assembly of the one or more flanges and the side edge of the photoelectric panel constituting the opposite coupling ends (21).

17. The photoelectric building block according to any one of the preceding claims, wherein the photoelectric panel (2) is a photovoltaic generator panel, or a light-emitting panel, or a moving image-emitting screen.

18. The photoelectric building block according to any one of the preceding claims, wherein the rigid support (1) is a ceramic panel or block, a mortar panel or block, or a plastic panel or block.

19. The photoelectric building block according to any one of the preceding claims, wherein the photoelectric panel (2) is cantilevered from the sunken channel (11).

20. The photoelectric building block according to any one of the preceding claims, wherein at least part of the front of the rigid support (1), which contains at least part of the sunken channel (11), and the back of the rigid support are not parallel, with the photoelectric panel being inclined with respect to the back, improving the sun exposure thereof.
